**Europäisches Patentamt**

**European Patent Office**

**Office européen des brevets**

(19)

(11) Veröffentlichungsnummer: **0 131 294**
**B1**

## (12) EUROPÄISCHE PATENTSCHRIFT

(45) Veröffentlichungstag der Patentschrift:
**03.06.87**

(51) Int. Cl.⁴: **G 03 C 1/68**

(21) Anmeldenummer: **84107959.3**

(22) Anmeldetag: **06.07.84**

(54) **Photopolymerisierbare wasserlösliche oder wasserdispergierbare Mischung.**

(30) Priorität: **08.07.83 DE 3324643**

(43) Veröffentlichungstag der Anmeldung:
**16.01.85 Patentblatt 85/3**

(45) Bekanntmachung des Hinweises auf die Patenterteilung:
**03.06.87 Patentblatt 87/23**

(84) Benannte Vertragsstaaten:
**DE FR GB NL**

(56) Entgegenhaltungen:
**DE - A - 1 597 748**
**DE - A - 2 749 639**

(73) Patentinhaber: **BASF Aktiengesellschaft,
Carl-Bosch-Strasse 38, D-6700 Ludwigshafen (DE)**

(72) Erfinder: **Wallbillich, Guenter, Dr., Eichendorffallee 15,
D-6707 Schifferstadt (DE)**
Erfinder: **Vyvial, Rudolf, Alwin-Mittasch-Platz 10,
D-6700 Ludwigshafen (DE)**

## Beschreibung

Die Erfindung betrifft fotopolymerisierbare wasserlösliche oder wasserdispergierbare Mischungen, bestehend aus einem Basispolymerisat, mindestens einer polymerisierbaren ethylenisch-ungesättigten Verbindung, mindestens einem Fotoinitiator und/oder Fotosensibilisator und mindestens einem Stabilisator.

Fotopolymerisierbare Mischungen der genannten Art, welche durch die Einwirkung von Licht unlöslich werden, lassen sich bekanntermassen für die Herstellung von Druckplatten, Überzugsmaterialien, Fotolacken und generell für die Fixierung, Reproduktion und Übertragung von Informationen einsetzen. Diese Mischungen müssen jedoch gegen eine spontane vorzeitige thermische Polymerisation, welche während der Lagerung oder des Transports eintreten kann, stabilisiert werden. Ein übliches Verfahren ist der Zusatz von Radikalfängern, Antioxydantien, Peroxidzerstörern, Wasserstoffakzeptoren und -donatoren, Elektronenakzeptoren und -donatoren und/oder Komplexbildnern. Auch Gase, wie z.B. Sauerstoff und Oxide des Stickstoffs können bei der Unterdrükkung der spontanen Polymerisation von fotopolymerisierbaren Mischungen eine wesentliche Rolle spielen. Im einzelnen sind eine Vielzahl von Verbindungen als geeignet beschrieben worden, wie z.B. phenolische Verbindungen, Hydrochinon und dessen Derivate, Amine, Nitrosamine, Nitro- und Nitrosoverbindungen, Hydroxylamine, N-Nitrosohydroxylaminderivate, Hydrazine, Harnstoff und dessen Derivate, Thioharnstoffe und dessen Derivate, Dithiocarbaminate, Pyridine, Chinoline, N-haltige Heterocyclen, Schwefel, Ascorbinsäure, Tocopherol, Methylenblau, Phosphine, Phosphorigsäureester und Komplexbildner wie Polyphosphor- und Polykieselsäuren und dessen Salze, Nitrilotriessigsäure, EDT, Hydroxycarbonsäuren. Auch Kombination von zwei oder mehreren Verbindungen der genannten Art sind meist im Hinblick auf synergistische Effekte bekannt geworden. Diese Inhibitoren der thermischen Polymerisation haben jedoch oft den Nachteil, dass sie die Lichtempfindlichkeit vermindern, wenn sie auch voll wirksam sind, um die Stabilität der lichtempfindlichen Materialien zu verbessern. Bei der Auswahl der Stabilisatoren ist auch deren Farbe zu beachten, da Verfärbungserscheinungen bei der Lagerung und bei den Reaktionen im Zusammenhang und der Verwendung der fotopolymerisierbaren Mischungen störend sind. Dies gilt um so mehr, da die meisten Stabilisatoren und/oder ihre Folgeprodukte in dem für die Fotopolymerisation wichtigen Wellenlängenbereich zwischen 300 und 500 nm absorbieren.

Insbesondere im Zusammenhang mit der Verwendung fotopolymerisierbarer Mischungen für die Speicherung, Reproduktion und Übertragung von Informationen müssen die angegebenen Nachteile bzw. Einschränkungen der bekannten Stabilisatoren sehr eingehend berücksichtigt werden. So hat sich in letzter Zeit auf dem vorstehend genannten Anwendungsgebiet die Notwendigkeit einer hohen Lichtempfindlichkeit sehr vergrössert. Die Verwendung der üblichen Inhibitoren der thermischen Polymerisation ergaben jedoch keine fotopolymerisierbaren Mischungen, die einerseits eine hohe Empfindlichkeit ergeben und andererseits bei der praktischen Anwendung keine Schwierigkeiten aufkommen lassen. Gerade die komplex zusammengesetzten Mischungen, welche die gewünschte hohe Lichtempfindlichkeit aufweisen, beinhalten bereits eine vielfältige Zahl von Möglichkeiten, welche eine vorzeitige Polymerisation auslösen können. Ebenso erfordert die hohe Lichtempfindlichkeit eine möglichst knappe Dosierung der Stabilisatoren, deren Auswahl durch die Forderung nach Transparenz im die Fotopolymerisation auslösenden Wellenlängenbereich dazu noch stark eingeschränkt ist.

Andererseits erfordert die Tendenz aus Umweltgründen fotopolymerisierbare Mischungen ohne organische Lösungsmittelgehalte herzustellen, bzw. den Anteil organischer Lösungsmittel sehr stark zu verringern, die Entwicklung weitgehend neuer Systeme. Für diese neuen fotopolymerisierbaren Mischungen eignen sich meist die vorbekannten Stabilisatoren nur sehr ungenügend. Dies trifft vor allem auch deshalb zu, weil hinsichtlich Empfindlichkeit und Auflösung, d.h. hoher Dichte der Wiedergabe, an die für die Informationsverarbeitung geeigneten fotopolymerisierbaren Mischungen sehr hohe Anforderungen gestellt werden.

Aufgabe der vorliegenden Erfindung war es daher, fotopolymerisierbare Mischungen bereitzustellen, welche bei vorgegebener Wasserlöslichkeit oder Wasserdispergierbarkeit hohe Lichtempfindlichkeit und hohe Auflösung, d.h. ausgezeichnete optische Eigenschaften, aufweisen und einen Inhibitor der thermischen Polymerisation enthalten, der die vorgenannten Nachteile vermeidet.

Es wurde nun gefunden, dass eine fotopolymerisierbare Mischung gemäss dem Oberbegriff des Hauptanspruchs die gestellte Aufgabe löst, wenn die fotopolymerisierbare Mischung als Stabilisator gegen thermische Polymerisation ein wasserlösliches Salz der salpetrigen Säure in einer Menge von 0,001 bis 1 Gew.-%, bezogen auf den Anteil an wasserfreier fotopolymerisierbarer Mischung, enthält. Als besonders vorteilhaft hat sich im Rahmen der Erfindung eine Menge zwischen 0,01 und 0,2 Gew.-% herausgestellt.

Als Stabilisatoren im Sinne der Erfindung eignen sich von den wasserlöslichen Salzen der salpetrigen Säure insbesondere Kalium- und Natriumnitrit in hervorragender Weise.

Die Zusammensetzung der fotopolymerisierbaren wasserlöslichen oder wasserdispergierbaren Mischungen ist an sich bekannt. Als fotoempfindliche Schicht von mindestens einem hydrophilen Bindemittel mit mindestens einem damit verträglichen fotopolymerisierbaren ethylenisch ungesättigten Monomeren und einem Fotoinhibitor kommen beispielsweise Mischungen in Frage, wie sie u.a. in den Britischen Patentschriften 786119, 834337, 835849, 1233883, 1251475 oder 1416440 beschrieben sind.

Als geeignete Basispolymere haben sich insbesondere Vinylalkohol-Polymere mit -CH$_2$CH(OH)-Struktureinheiten in der Polymerhauptkette erwiesen sowie deren in Wasser lösliche oder dispergierbare Copolymerisate und Derivte, wie Ester, Ether oder Acetale. Besonders geeignet sind die bekannten verseiften Polyvinylester von aliphatischen Monocarbonsäuren mit 1 bis 4 C-Atomen, wie Polyvinylacetate oder Polyvinylpropionate, deren mittlerer Polymerisationsgrad 200 bis 3000 und insbesondere 250 bis 750, und deren Verseifungsgrad 65 bis etwa 100 und insbesondere 80 bis 88 Mol-% beträgt. Auch Gemische von verseiften Vinylester-Polymeren oder -Copolymeren mit unterschiedlichem Polymerisationsgrad und/oder unterschiedlichem Verseifungsgrad können angewandt werden. Ferner seien in diesem Zusammenhang die Umsetzungsprodukte von Vinylalkohol-Polymeren mit Acryl- und/oder Methacrylsäureanhydrid erwähnt, wobei diese Umsetzungsprodukte im allgemeinen 3 bis 30 Gew.-%, bezogen auf das Umsetzungsprodukt, an Acryloyl- oder Methacryloyl-Gruppen eingebaut enthalten, als auch die wasserlöslichen Umsetzungsprodukte von Vinylalkohol-Polymeren mit Ethylenoxid, bzw. Pfropfungsprodukte von Vinylalkohol(derivaten) auf Polyethylenoxid, wobei der Anteil der Ethylenoxid-Einheiten im oxyethylierten Vinylalkohol-Polymer 5 bis 75 Gew.-%, insbesondere 10 bis 60 Gew.-% beträgt. Diese Umsetzungsprodukte von Vinylalkohol-Polymeren können als alleinige Polymer-Komponente in den Mischungen enthalten sein; sie können aber auch in Mischung mit anderen Vinylalkohol-Polymeren, insbesondere den erwähnten verseiften Polyvinylestern vorliegen, wobei dann der Anteil der Umsetzungsprodukte des Polyvinylalkohols vorteilhaft 30 Gew.-%, bezogen auf die gesamten in der Mischung enthaltenen Vinylalkohol-Polymeren, oder mehr beträgt. Darüber hinaus ist es möglich, dass die genannten Vinylalkohol-Polymeren oder -Copolymeren und/oder deren Derivate mit bis zu etwa 30 Gew.-%, bezogen auf den Polymeranteil des jeweiligen fotopolymerisierbaren Materials, an verträglichen Melamin-Formaldehyd-Harzen, Harnstoff-Formaldehyd-Harzen oder Phenol-Formaldehyd-Harzen sind.

Daneben genügen als Basispolymere auch die bekannten Cellulosederivate, Gelatine, Alginate und Polyvinylpyrrolidone den gestellten Anforderungen.

Als fotopolymerisierbare, ethylenisch ungesättigte Monomere für die Mischung kommen u.a. die bekannten Monomeren mit einem Molekulargewicht unter 2000 in Frage, die für polymere Bindemittel enthaltende fotopolymerisierbare Materialien an sich bekannt sind, wobei sich natürlich Art und Menge der fotopolymerisierbaren Monomeren nach dem mitverwendeten polymeren Bindemittel richten, mit dem sie verträglich sein sollen. Sehr geeignet sind fotopolymerisierbare niedermolekulare Verbindungen mit 2 oder mehr ethylenisch ungesättigten fotopolymerisierbaren Doppelbindungen allein oder deren Mischungen mit Monomeren mit nur einer olefinisch ungesättigten fotopolymerisierbaren Doppelbindung, wobei der Anteil der Monomeren mit nur einer Doppelbindung von mitverwandten Polymerbindemitteln abhängt. Es ist unter bestimmten Voraussetzungen selbstverständlich möglich, als fotopolymerisierbare Monomere überwiegend nur solche einzusetzen, die nur eine fotopolymerisierbare Doppelbindung im Molekül enthalten, insbesondere dann, wenn das mitverwandte Polymerbindemittel selber einen hohen Anteil an fotovernetzbaren Doppelbindungen enthält, wie z.B. im Fall der acryloierten und/oder methacryloierten Vinylalkohol-Polymerisate. Im allgemeinen haben die fotopolymerisierbaren Monomeren einen Siedepunkt von über 100 °C bei Atmosphärendruck.

Als Beispiele für fotopolymerisierbare ungesättigte niedermolekulare Verbindungen seien genannt: Mono-, Di- und Polyacrylate und -methacrylate, wie sie durch Veresterung von Acrylsäure oder Methacrylsäure mit ein- oder mehrwertigen niedermolekularen Alkoholen hergestellt werden können. Hierzu gehören u.a. die Di- und Tri-(meth)acrylate von Ethylenglykol, Diethylenglykol, Triethylenglykol, Polyethylenglykol mit einem Molekulargewicht bis etwa 500, 1,2-Propandiol, 1,3-Propandiol, Polypropylenglykolen mit einem Molekulargewicht bis etwa 500, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole oder Polyole, wie z.B. Ethylenglykol-mono-(meth)acrylat, 1,2-Propandiol-mono-(meth)acrylat, 1,3-Propandiol-mono-(meth)acrylat und das Di-, Tri- oder Tetraethylenglykol-mono-(meth)acrylat. Weiterhin kommen Verbindungen in Betracht, die Urethangruppen und/oder Amidgruppen enthalten, wie die aus aliphatischen Diolen der vorstehend genannten Art, organischen Diisocyanaten, wie z.B. Hexamethylendiisocyanat, Toluylendiisocyanat und Isophorodiisocyanat, und Hydroxyalkyl-(meth)acrylaten der oben genannten Art hergestellten niedermolekuleren Verbindungen. Genannt seien ferner auch Acrylsäure, Methacrylsäure, (Meth)acrylate von Alkanolen mit 1 bis 6 C-Atomen, Mono- und Bis-(meth)acrylamide von aliphatischen oder aromatischen Diaminen mit 2 bis 8 C-Atomen, wie von Ethylendiamin, Propylendiamin, Butylendiamin, Pentamethylendiamin, Hexamethylendiamin, Octamethylendiamin oder Xylylendiamin, als auch Derivate der (Meth)acrylamide, z.B. Hydroymethyl-(meth)-acrylamid, oder insbesondere die Umsetzungsprodukte von 2 Mol N-Hydroxymethyl-(meth)-acrylamid mit einem Mol eines aliphatischen Diols, z.B. Ethylenglykol oder Propylenglykol.

Die Auswahl der geeigneten Monomeren richtet sich nach den mitverwendeten Polymerbindemitteln und nach den angestrebten Eigenschaften des Endproduktes und ist dem Fachmann geläufig. Werden als Polymerbindemittel Vinylalkoholpolymerisate eingesetzt, eignen sich als Monomere besonders die wasserlöslichen Monomere, wie z.B. die Hydroxyalkyl-(meth)acrylate, die Mono-oder Di-(meth)acrylate von Polyethylenglykolen oder Mischungen hiervon mit Di- oder Poly(meth)acrylaten der oben genannten Art.

Die fotopolymerisierbaren Mischungen enthalten die Polymeren und die fotopolymerisierbaren ethylenisch ungesättigten Monomeren im allgemeinen in einer Menge von etwa 50 bis 90 Gew.-% bzw. von 10 bis 50 Gew.-%, jeweils bezogen auf die Summe von Polymeren und Monomeren. Der Anteil der Monomeren kann in einzelnen Fällen auch grösser oder kleiner sein. So ist es beispielsweise möglich, den Anteil der Monomeren unter 10 Gew.-% abzusenken, wenn in den Mischungen ungesättigte Polymere mit einem hinreichend hohen Gehalt an fotovernetzbaren Doppelbindungen enthalten sind.

Als Fotopolymerisationsinitiatoren, die in den Mischungen im allgemeinen in Mengen von 0,05 bis 10 Gew.-% und insbesondere von 0,5 bis 5 Gew.-%, bezogen auf die Mischung, enthalten sind, kommen die bekannten und üblichen Fotopolymerisationsinitiatoren und Systeme für die Auslösung einer Fotopolymerisation bei Bestrahlung mit aktinischem Licht in Frage, wie sie hinreichend in der einschlägigen Fachliteratur beschrieben sind. Genannt seien z.B. Acyloine und deren Derivate, wie Benzoinalkylether, z.B. Benzoinmethylether oder Benzoinisopropylether, α-Methylolbenzoin und dessen Ether oder α-Methylbenzoin und dessen Ether; 1,2-Diketone und deren Derivate wie Diacetyl, Benzil, Benzilketale wie Benzildimethylketal, Benzilmethylethylketal, Benzilmethylbenzylketal der Benzylethylenglykol-monoketal; Acylphosphinoxid-Verbindungen, insbesondere Acyl-diarylphosphinoxide und spezielle Acyldiphenylphosphinoxide, deren Acylrest sich von einer tertiären aliphatischen oder cycloaliphatischen Carbonsäure oder von einer mindestens in 2,6-Stellung substituierten Benzoesäure ableitet, wie sie in der DE-A-2 909 992 ausführlich beschrieben sind. Die Fotopolymerisationsinitiatoren können allein oder in Mischung miteinander oder auch in Mischung mit Aktivatoren, wie z.B. tertiären Aminen, eingesetzt werden.

Im Rahmen der Ausarbeitung der erfindungsgemässen Mischungen hat es sich für manche Anwendungsfälle als zweckmässig erwiesen, neben den wasserlöslichen Salzen der salpetrigen Säure noch weitere Substanzen zuzusetzen.

Hierzu gehören insbesondere die Inhibitoren gegen die thermische Polymerisation, wie Hydrochinon, p-Methoxyphenol, m-Dinitrobenzol, p-Chinon, Methylenblau, β-Naphthol, N-Nitrosamine, wie N-Nitrosodiphenylamin oder die Salze, insbesondere die Alkali- und Aluminiumsalze des N-Nitroso-cyclohexyl-hydroxylamins. Diese Inhibitoren werden im allgemeinen in Mengen von 0,01 bis 2,0 Gew.-%, bezogen auf das Material der Mischung, neben den Salzen der salpetrigen Säure verwendet, wobei die Gesamtmenge 3 Gew.-% nicht überschreiten sollte.

Die fotopolymerisierbaren Mischungen können darüber hinaus als weitere Zusätze Weichmacher, Farbstoffe, Pigmente oder dergleichen enthalten.

Zum Belichten der lichtempfindlichen Aufzeichnungsmaterialien werden Lichtquellen eingesetzt, die aktinisches Licht im Wellenlängenbereich von im allgemeinen 250 bis 500 nm, vorzugsweise im Bereich von 300 bis 450 nm auszustrahlen vermögen und deren Emissionsmaxima im allgemeinen im Bereich der Absorption der Fotoinitiatoren liegen.

Die erfindungsgemäss charakterisierten fotopolymerisierbaren Mischungen weisen neben der erhöhten Empfindlichkeit und der hohen Auflösung bei der Informationsverarbeitung den Vorteil auf, dass keine umweltbelastenden organischen Lösungsmittel benötigt werden. Vor allem aber haben diese Mischungen gemäss der Erfindung eine beträchtlich erhöhte Stabilität bei Raumtemperatur und bei erhöhter Temperaturen bis zu 100 °C. Der Zeitraum, während dessen bei thermischer oder auch andersartiger Belastung keine spontane Polymerisation auftritt, ist häufig auf das 2- bis 10-fache verlängert. In manchen Fällen werden hochempfindliche Mischungen durch die erfindungsgemässe Stabilisierung überhaupt erst technisch handhabbar.

Die nachstehenden Beispiele und Vergleichsversuche erläutern die Erfindung. Die in den Beispielen und Vergleichsversuchen angegebenen Teile beziehen sich, sofern nicht anders angegeben, auf das Gewicht.

Beispiel 1

67,5 Teile eines Polyvinylpyrrolidons des Molekulargewichts 600 000 bis 800 000 (K-Wert 92) werden bei 90 °C in 400 Teilen vollentsalztem Wasser gelöst. Nach Abkühlen auf 70 °C werden 30 Teile des Diethers aus 1 Mol Ethylenglykol und 2 Molen N-Hydroxymethylacrylamid, 0,1 Teile N-Nitrosocyclohexylhydroxylamin, 0,01 Teile Natriumnitrit und 2,5 Teile α-Methylolbenzoinmethylether hinzugefügt. Sobald alle Bestandteile gelöst sind, wird die Ansatzlösung filtriert und unter vermindertem Druck entgast. Durch geeignete Formgebung werden lichtempfindliche Elemente aus ihr hergestellt.

Eine Probe wird einem Stabilitätstest unter Ausschluss aktinischer Strahlung in einer verschlossenen Ampulle bei 80 °C unterworfen: Sie bleibt 46 Stunden unverändert, während eine ohne Verwendung von Natriumnitrit hergestellte Lösung bereits nach 6 Stunden erstarrt. Der Stabilitätsfaktor beträgt somit 7,7.

Beispiel 2

145 Teile eines Polyvinylpyrrolidons des Molekulargewichts 600 000 bis 800 000 (K-Wert 92) und 135 Teile eines teilverseiften Polyvinylacetats, das 22% Polyoxyethylensegmente gebunden enthält (mittleres Molekulargewicht 25 000 bis 30 000) werden bei 90 °C in einer Lösung von 1,5 Teilen Natriumnitrit in 450 Teilen vollentsalztem Wasser gelöst. Hierauf wird bei 70 °C eine Lösung von 12,5 Teilen Benzildimethylketal, 0,1 Teilen N-Nitrosodiphenylamin und 0,025 Teilen Eosin in einer Mischung von 110 Teilen β-Hydroxyethylmethacrylat und 88 Teilen 1,1,1-Trimethylolpropantrimethacrylat langsam zur wässrigen Lösung hinzugefügt. Nach Filtration und Entgasen unter vermindertem Druck wird die dickflüssige Lösung zur Herstellung lichtempfindlicher Elemente verwendet.

Der im oben beschriebenen Stabilitätstest ermittelte Stabilitätsfaktor beträgt 5,6.

## Beispiel 3

68 Teile eines N-Vinylpyrrolidon/Vinylacetat-Copolymerisats (Gew.-Verh. 60:40) mit einem K-Wert von 32 und 0,05 Teile Natriumnitrit werden in 67 Teilen vollentsalztem Wasser bei 70 °C gelöst. Anschliessend wird eine Lösung von 5 Teilen 1,1,1-Trimethylolpropantriacrylat, 2,0 Teilen Benzildimethylketal und 0,1 Teilen N-Nitrosocyclohexylhydroxylamin in 25 Teilen β-Hydroxyethylmethacrylat eingerührt. Die Ansatzlösung wird filtriert und bei vermindertem Druck entgast. Durch geeignete Formgebung werden lichtempfindliche Elemente aus ihr hergestellt.

Beim Stabilitätstest (80 °C, verschlossene Ampulle) scheiden sich nach 36 Stunden aus der Lösung die ersten Polymerisationsteilchen ab. In einem ohne Natriumnitrit hergestellten Vergleichsansatz wird schon nach 11 Stunden Polymerisat beobachtet. Der Stabilitätsfaktor beträgt somit 3,3.

## Beispiel 4

174 Teile eines N-Vinylpyrrolidon/Vinylacetat-Copolymerisats (Gew.-Verh. 60:40) mit einem K-Wert von 32 und 75 Teile eines teilverseiften Polyvinylacetats, das 22% Polyoxyethylensegmente gebunden enthält (mittleres Molekulargewicht 25000 bis 30000) werden bei 80 °C in 210 Teilen vollentsalztem Wasser gelöst. Sodann wird die Lösung von 0,4 Teilen Natriumnitrit in 10 Teilen Wasser hinzugefügt. Schliesslich wird eine Lösung von 6,0 Teilen α-Methylolbenzoinmethylether, 0,3 Teilen N-Nitrosodiphenylamin und 0,015 Teilen Eosin in 45 Teilen 1,1,1-Trimethylolpropantriacrylat eingerührt. Nach Filtration und Entgasung unter vermindertem Druck werden aus der Lösung lichtempfindliche Elemente hergestellt. Der Stabilitätsfaktor beträgt 4,1.

## Beispiel 5

432 Teile eines teilverseiften Polyvinylacetats (Verseifungsgrad 88 Mol-%; mittlerer Polymerisationsgrad 500) werden in 610 Teilen vollentsalztem Wasser bei 90 °C gelöst. Sodann werden 0,08 Teile Natriumnitrit, gelöst in 16 Teilen Wasser, eine Lösung von 29 Teilen des Diethers aus 1 Mol Ethylenglykol und 2 Molen N-Hydroxymethylacrylamid sowie von 11 Teilen α-Methylolbenzoinmethylether in 300 Teilen β-Hydroxyethylmethacrylat hinzugefügt. Die homogene Lösung wird filtriert und bei vermindertem Druck entgast. Anschliessend werden lichtempfindliche Elemente aus ihr hergestellt.

Im Stabilitätstest (80 °C, geschlossene Ampulle) wird nach 35 Stunden der Beginn der Polymerisatbildung beobachtet. Ein ohne Natriumnitrit hergestellter Vergleichsansatz polymerisiert nach 2 Stunden. Der Stabilitätsfaktor beträgt somit 17,5.

## Beispiel 6

Der Versuch des Beispiels 5 wird mit 0,8 Teilen (statt 0,08) Natriumnitrit wiederholt. Die fertige Ansatzlösung ist nun leicht gelb gefärbt; die Belichtungseigenschaften der daraus hergestellten fotopolymerisierbaren Elemente sind im wesentlichen unverändert. Die Ansatzlösung bleibt bei 80 °C 52 Stunden stabil; der Stabilitätsfaktor beträgt 26.

## Beispiel 7

495 Teile eines teilverseiften Polyvinylacetats (Verseifungsgrad 82 Mol-%, mittlerer Polymerisationsgrad 500 bis 600) werden 520 Teilen vollentsalztem Wasser bei 90 °C unter Rühren gelöst. 0,2 Teile Natriumnitrit in 10 Teilen Wasser werden hinzugefügt. Dann wird eine Lösung von 19 Teilen Tetraethylenglykoldimethacrylat, 15 Teilen α-Methylolbenzoinmethylether, 1,5 Teilen 2,6-Di-tert.-butyl-p-kresol und 0,05 Teilen Eosin in 405 Teilen β-Hydroxyethylmethacrylat eingerührt. Die Ansatzlösung wird nach Filtration und Entgasung zur Herstellung lichtempfindlicher Elemente verwendet.

Im Stabilitätstest erweist sie sich über 38 Stunden stabil; ein Vergleichsansatz ohne Natriumnitrit polymerisiert nach 3 Stunden. Der Stabilitätsfaktor ist somit 12,7.

## Beispiel 8

1036 Teile eines teilverseiften Polyvinylacetats (Verseifungsgrad 82 Mol-%, mittlerer Polymerisationsgrad 500 bis 600) werden in 1050 Teilen vollentsalztem Wasser bei 90 °C unter Rühren gelöst. 0,10 Teile Natriumnitrit werden als 5%ige wässrige Lösung hinzugegeben. Sodann wird eine Lösung von 37 Teilen Tetraethylenglykoldimethacrylat, 29 Teilen Benzildimethylketal, 2,9 Teilen 2,6-Di-tert.-butyl-p-kresol und 0,10 Teile Eosin in 880 Teilen β-Hydroxyethylmethacrylat eingerührt. Die homogene Lösung wird filtriert, entgast und anschliessend zu lichtempfindlichen Elementen verarbeitet.

Im Test bei 80 °C ist die fertige Lösung 68 Stunden stabil. Der Vergleich mit der nitritfreien Rezeptur ergibt den Stabilitätsfaktor 13,6.

## Beispiel 9

Beispiel 8 wird durch Verwendung der doppelten Menge an Natriumnitrit abgewandelt. Die Ansatzlösung bleibt 86 Stunden stabil; Stabilitätsfaktor 17,2.

## Beispiel 10

378 Teile eines teilverseiften Polyvinylacetats (Verseifungsgrad 82 Mol-%; mittlerer Polymerisationsgrad 500 bis 600) werden durch mehrstündiges Rühren in 450 Teilen vollentsalztem Wasser bei 90 °C gelöst. Nach Abkühlen auf 70 °C werden 162 Teile eines teilverseiften Polyvinylacetats (Verseifungsgrad 80 Mol-%), das 22% Polyoxyethylensegmente gebunden enthält (mittleres Molekulargewicht 25000 bis 30000), unter weiterem Rühren hinzugefügt. Sodann werden 0,2 Teile Natriumnitrit, gelöst in 10 Teilen Wasser, und anschliessend eine Lösung von 80 Teilen Butandiol-1,4-dimethacrylat, 15 Teilen Benzildimethylketal, 1,5 Teilen 2,6-Di-tert.-butyl-p-kesol, 0,2 Teilen N-Nitrosodiphenylamin und 0,03 Teilen Eosin in 360 Teilen β-Hydroxyethylmethacrylat eingerührt. Die Ansatzlösung wird nach Filtration und Entgasen zur Herstellung lichtempfindlicher Elemente verwendet. Im Stabilitätstest (80 °C) traten nach 62 Stunden die ersten sichtbaren Polymerisationserscheinungen auf. Der nitritfreie Vergleichsansatz blieb hingegen 15 Stunden stabil. Stabilitätsfaktor: 4,1.

Beispiel 11

222 Teile eines teilverseiften Polyvinylactats (Verseifungsgrad 83 Mol-%, mittlerer Polymerisationsgrad 600) werden in 318 Teilen vollentsalztem Wasser bei 90 °C gelöst. Nach Abkühlen auf 70 °C werden 95 Teile eines teilverseiften Polyvinylacetats, das 22% Polyethylenglykolsegmente gebunden enthält (mittleres Molekulargewicht 25000 bis 30000), eingerührt. Hierauf werden 0,13 Teile Natriumnitrit, gelöst in 5 Teilen Wasser hinzugegeben. Im weiteren wird eine Lösung von 48 Teilen Butandiol-1,4-dimethacrylat, 3,8 Teilen 2,4,5-Trimethylbenzoyldiphenylphosphinoxyd, 1,0 Teilen 2,6-Di-tert.-butyl-p-kresol, 0,13 Teilen N-Nitrosodiphenylamin, 0,13 Teilen 85% Phosphorsäure, 0,07 Teilen Hydrochinon, 0,07 Teilen Hydrochinonmonomethylether und 0,032 Teilen Eosin in 281 Teilen β-Hydroxyethylmethacrylat zugefügt und zu einer homogenen Lösung verarbeitet, aus der lichtempfindliche Elemente hergestellt werden.

Im Stabilitätstest bei 80 °C in einer geschlossenen Ampulle entstand nach 24 Stunden Polymerisat. Der Vergleichsansatz ohne Natriumnitrit war nur 13 Stunden unverändert. Der Stabilitätsfaktor beträgt somit 1,8.

Beispiel 12

343 Teile eines teilverseiften Polyvinylacetats (Verseifungsgrad 83 Mol-%); mittlerer Polymerisationsgrad 600) werden in 520 Teilen vollentsalztem Wasser bei 90 °C gelöst. Nach Abkühlen auf 70 °C werden 177 Teile eines teilverseiften Polyvinylacetats, das 22% Polyethylenoxydsegmente gebunden enthält (mittleres Molekulargewicht 25000 bis 30000) eingerührt. Hierauf wird eine Lösung von 74 Teilen Butandiol-1,4-dimethacrylat, 9 Teilen 2,4,6-trimethylbenzoyldiphenylphosphinoxyd, 1,5 Teilen 2,6-Di-tert.-butyl-p-kresol und 0,2 Teilen N-Nitrosodiphenylamin in 416 Teilen β-Hydroxyethylmethacrylat hinzugefügt. Die homogene Ansatzlösung wird filtriert und entgast. Zur Erhöhung der thermischen Stabilität werden Anteile dieser Lösung zusätzlich mit Natriumnitrit versetzt und sodann auf ihre Neigung zu spontaner Polymerisation bei 80 °C in der üblichen Weise geprüft (s. Tabelle).

| Zusatz | Haltbarkeit im Stabilitätstest | Stabilitätsfaktor |
|---|---|---|
| 0 | 9 | = 1 |
| 0,01% $NaNO_2$ | 17 | 1,8 |
| 0,02% $NaNO_2$ | 31 | 3,4 |
| 0,05% $NaNO_2$ | 40 | 4,4 |

Patentansprüche

1. Fotopolymerisierbare wasserlösliche oder wasserdispergierbare Mischung, bestehend aus einem Basispolymerisat, mindestens einer polymerisierbaren ethylenisch-ungesättigten Verbindung, mindestens einem Fotoinitiator und/oder Fotosensibilisator und mindestens einem Stabilisator, dadurch gekennzeichnet, dass die fotopolymerisierbare Mischung als Stabilisator gegen thermische Polymerisation ein wasserlösliches Salz der salpetrigen Säure in einer Menge von 0,001 bis 1 Gew.-%, bezogen auf den Anteil an wasserfreier fotopolymerisierbarer Mischung enthält.

2. Fotopolymerisierbare wasserlösliche oder wasserdispergierbare Mischung gemäss Anspruch 1, dadurch gekennzeichnet, dass sie das wasserlösliche Salz der salpetrigen Säure in einer Menge von 0,01 bis 0,2 Gew.-% enthält.

3. Fotopolymerisierbare wasserlösliche oder wasserdispergierbare Mischungen gemäss Anspruch 1, dadurch gekennzeichnet, dass die fotopolymerisierbare Mischung als Stabilisator neben einem wasserlöslichen Salz der salpetrigen Säure noch Hydrochinon und dessen Derivate, Phenolverbindungen und/oder N-Nitrosoverbindungen enthält.

Claims

1. A photopolymerizable water-soluble or water-dispersible mixture consisting of a base polymer, at least one polymerizable ethylenically unsaturated compound, at least one photoinitiator and/or photosensitizer, and at least one stabilizer, wherein the photopolymerizable mixture contains, as stabilizer against thermal polymerization, from 0.001 to 1% by weight, based on the amount of anhydrous photopolymerizable mixture, of a water-soluble salt of nitrous acid.

2. A photopolymerizable water-soluble or water-dispersible mixture as claimed in claim 1, which contains from 0.01 to 0.2% by weight of a water-soluble salt of nitrous acid.

3. A photopolymerizable water-soluble or water-dispersible mixture as claimed in claim 1, which contains, as a further stabilizer, in addition to a water-soluble salt of nitrous acid, hydroquinone, a derivative thereof, a phenol compound and/or an N-nitroso compound.

Revendications

1. Mélange photopolymérisable, soluble dans l'eau ou dispersable dans l'eau, constitué d'un polymérisat de base, d'au moins un composé polymérisable insaturé éthylèniquement, d'au moins un photoinitiateur et/ou photosensibilisateur et d'au moins un stabilisant, caractérisé par le fait que le mélange photopolymérisable contient, comme stabilisant contre la polymérisation thermique, un sel soluble dans l'eau de l'acide nitreux, en proportion de 0,001 à 1% en poids, rapportée à la partie de mélange photopolymérisable exempt d'eau.

2. Mélange photopolymérisable, soluble dans l'eau ou dispersable dans l'eau selon la revendication 1, caractérisé par le fait qu'il contient le sel soluble dans l'eau d'acide nitreux en proportion de 0,01 à 0,2% en poids.

3. Mélange photopolymérisable, soluble dans l'eau ou dispersable dans l'eau selon la revendication 1, caractérisé par le fait que le mélange photopolymérisable contient comme stabilisant, à côté d'un sel soluble dans l'eau de l'acide nitreux, en outre, de l'hydroquinone et ses dérivés, des composés phénoliques et/ou des composés N-nitroso.